# EUROPEAN PATENT APPLICATION

(11) **EP 3 873 182 A1**
(43) Date of publication of application: **01.09.2021**
(21) Application number: 19876430.0
(22) Date of filing: 24.09.2019
(51) Int. Cl.: H05K 3/00, H01L 23/12, H01L 25/00, H05K 1/02

(54) **METHOD FOR MANUFACTURING DEVICE CONNECTED BODY, AND DEVICE CONNECTED BODY**

(30) Priority: 22.10.2018 JP 2018198607
(71) Applicant: TOYOBO CO., LTD., Osaka-shi Osaka 530-8230 (JP)
(72) Inventor: OKUYAMA,Tetsuo, Otsu-shi, Shiga 520-0292 (JP); ICHIMURA,Shunsuke, Otsu-shi, Shiga 520-0292 (JP); HAYASHI,Miyuki, Otsu-shi, Shiga 520-0292 (JP)
(74) Representative: Vossius & Partner Patentanwälte Rechtsanwälte mbB
(86) International application number: PCT/JP2019/037284
(87) International publication number: WO 2020/084981

(57) **Abstract**

A method for manufacturing a device connected body, including: a step A for readying a first laminate having, in the order listed, an inorganic substrate, a resin layer, and a plurality of devices mounted on the resin layer so that a gap is present therebetween; a step B for forming, on the first laminate, an elastomer layer so as to cover the plurality of devices and the gap portion and obtaining a second laminate; and a step C for peeling the inorganic substrate. The resin layer is either formed as a plurality of resin layers in advance at least at positions corresponding to the plurality of devices, or formed as a plurality of resin layers at least at positions corresponding to the plurality of devices by removing a part of the resin layer after step C for peeling the inorganic substrate.

## Description

### TECHNICAL FIELD

The present invention relates to a method for manufacturing a device connected body, and a device connected body.

### BACKGROUND ART

In recent years, there has been an increasing demand for seats which are equipped with a plurality of devices mounted at intervals and exhibit both flexibility and elasticity. Such sheets are supposed to be used by being fitted to, for example, a curved surface such as the body. Such sheets are also supposed to be used in electronic devices having a bent portion and electronic devices capable of being wound.

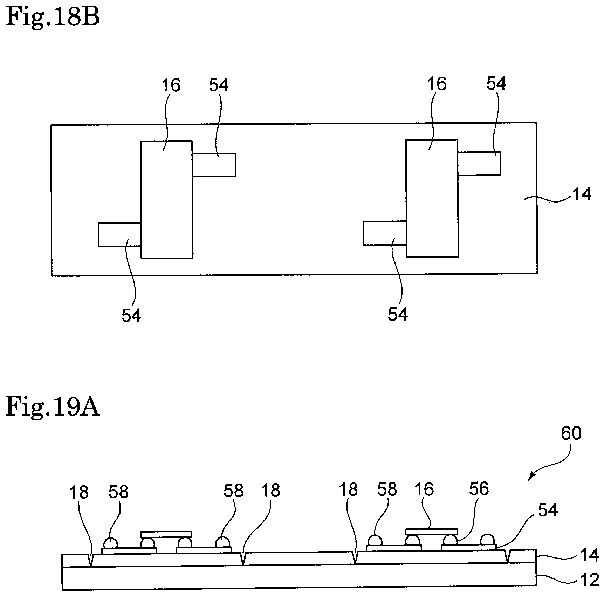

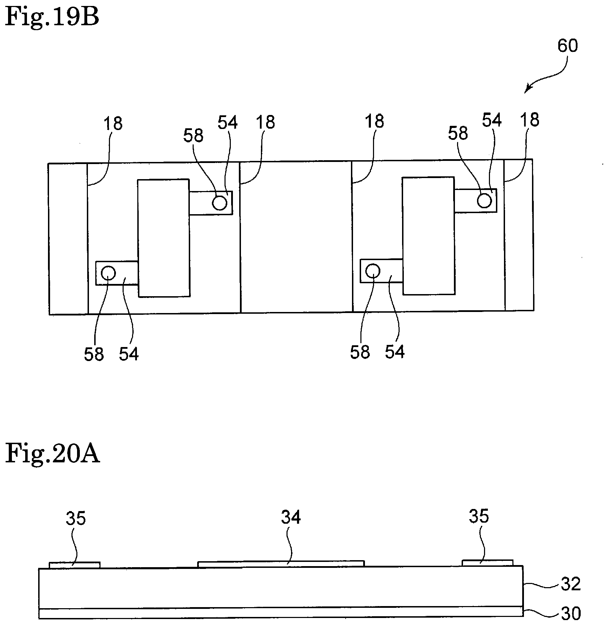

Patent Document 1 discloses a circuit board apparatus in which a plurality of electronic members are provided on a stretchable circuit board. As a method for manufacturing a stretchable circuit board, Patent Document 1 describes that a copper foil on a copper-plated polyimide substrate is etched to form a meander-type pattern and the polyimide portion is separated by laser processing so that the polyimide width is 250 µm around the wiring, and a stretchable circuit board is thus obtained (paragraph [0136], Fig. 19).

### PRIOR ART DOCUMENTS

### PATENT DOCUMENTS

Patent Document 1: JP-A-2018-116959

### SUMMARY OF THE INVENTION

### PROBLEMS TO BE SOLVED BY THE INVENTION

However, in the method for manufacturing a circuit board as described in Patent Document 1, it is required to subject the polyimide substrate to laser processing so as to follow the meander-type pattern of the wiring and the productivity is thus poor. In particular, when the wiring pattern has a narrow pitch, it is required to perform laser processing at high precision, and this is not suitable for mass production. A polyimide substrate exhibits flexibility but does not exhibit elasticity, and it is impossible to impart elasticity to the circuit board in the case of a configuration in which the polyimide substrate is not subjected to laser processing.

The present invention has been made in view of the above-mentioned problems, and an object thereof is to provide a method for manufacturing a device connected body, by which a device connected body is easily manufactured and can be mass-produced. Another object of the present invention is to provide the device connected body.

### MEANS FOR SOLVING THE PROBLEMS

The present inventors have conducted diligent investigations on a method for manufacturing a device connected body. As a result, the present inventors have found out that a device connected body is easily manufactured and can be mass-produced if the following configuration is adopted, and have completed the present invention.

In other words, the method for manufacturing a device connected body according to the present invention includes:
a step A of preparing a first laminate including an inorganic substrate, a resin layer, and a plurality of devices mounted on the resin layer at intervals in this order;
a step B of obtaining a second laminate by forming an elastomer layer on the first laminate so as to cover the plurality of devices and the interval portion; and
a step C of peeling off the inorganic substrate, and
in the method, the resin layer is formed as a plurality of resin layers at least at positions corresponding to the plurality of devices in advance or as a plurality of resin layers at least at positions corresponding to the plurality of devices by removing a part of the resin layer after the step C of peeling off the inorganic substrate.

According to the configuration, it is possible to obtain a device connected body in which a plurality of devices are mounted on an elastic elastomer layer at intervals if only an elastomer layer is formed on the first laminate so as to cover the plurality of devices and the interval portion (step B) and then the inorganic substrate is peeled off (step C). Hence, the productivity is excellent.

Here, the resin layer is formed (1) as a plurality of resin layers at least at positions corresponding to the plurality of devices in advance or (2) as a plurality of resin layers at least at positions corresponding to the plurality of devices by removing a part of the resin layer after the step C of peeling off the inorganic substrate. In other words, although the resin layer is laminated on each device, the resin layer corresponding to each device is not continuous. Hence, one device and another device are connected to each other only by the elastomer layer. As a result, the device connected body obtained by the manufacturing method according to the present invention exhibits elasticity.

In the configuration, it is preferable to form a cutting line for removing a part of the resin layer on the resin layer by laser irradiation prior to the step B of obtaining a second laminate.

If the configuration is adopted in which a cutting line for removing a part of the resin layer is formed on the resin layer by laser irradiation prior to the step B of obtaining a second laminate, the inorganic substrate may be irradiated with laser but the elastomer layer is not irradiated with laser when the irradiation amount of laser is large. Hence, the device connected body can be stably manufactured.

If the configuration is adopted in which a cutting line for removing a part of the resin layer is formed on the resin layer by laser irradiation prior to the step B of obtaining a second laminate, it is easy to secure the positional accuracy of laser irradiation of the resin layer since the laser irradiation is performed on the inorganic substrate.

In the configuration, it is preferable that the step B of obtaining a second laminate includes a step B-1 of laminating an elastomer layer with a supporting base material on the first laminate and the method for manufacturing a device connected body further includes a step D of peeling off the supporting base material.

If an elastomer layer with a supporting base material is used, it is possible to obtain a second laminate by easily forming an elastomer layer on the first laminate.

In the configuration, it is preferable that the elastomer layer has an elastic wiring pattern on a surface thereof for connecting the devices to each other.

If the elastomer layer has an elastic wiring pattern on a surface thereof for connecting the devices to each other, wiring between devices can be performed at the same time while maintaining the elasticity between the devices when the elastomer layer is formed on the first laminate.

In the configuration, it is preferable that the wiring pattern is bellows type metal wiring or elastic metal paste wiring.

If the wiring pattern is bellows type metal wiring or elastic metal paste wiring, suitable elasticity between devices can be maintained while maintaining electrical connection between the devices.

In the configuration, it is preferable to include:
a step E of forming a cutting line for removing a part of the resin layer on the resin layer by laser irradiation after the step C of peeling off the inorganic substrate; and
a step F of forming a plurality of resin layers at least at positions corresponding to the plurality of devices by removing the part.

If a cutting line for removing a part of the resin layer is formed on the resin layer by laser irradiation after the step C of peeling off the inorganic substrate (step E) and a plurality of resin layers are formed at least at positions corresponding to the plurality of devices by removing the part (step F), it is possible to confirm the shape after the devices are embedded in the elastomer layer and then to remove the unnecessary portion of the resin layer. In other words, the elastomer layer and the first laminate (particularly the resin layer) may be deformed in step B, but it is possible to confirm the deformation of these and then to select and remove the unnecessary resin layer portion according to the configuration.

In the configuration, it is preferable to include a step G of forming an elastic wiring pattern for connecting the plurality of devices to each other on the first laminate prior to the step B of obtaining a second laminate.

If an elastic wiring pattern for connecting the plurality of devices to each other is formed on the first laminate prior to the step B of obtaining a second laminate, it is possible to secure electrical connection between the device and the wiring pattern.

In the configuration, it is preferable that the device is a sensor element or a light emitting element.

If the device is a sensor element, the device can be attached to, for example, a surface (for example, skin) of which the shape changes to measure the biological information, and the like. If the device is a light emitting element, the device can be an elastic display.

The device connected body according to the present invention includes:
an elastomer layer;
a plurality of resin layers adhering to the elastomer layer;
a plurality of devices interposed between the elastomer layer and the plurality of resin layers; and
an elastic wiring pattern for connecting the plurality of devices to each other.

According to the configuration, although the resin layer is laminated on each device, the resin layer corresponding to each device is not continuous. Hence, one device and another device are connected to each other only by the elastomer layer or only by the elastomer layer and the elastic wiring pattern. As a result, the device connected body obtained according to the present invention exhibits elasticity. In other words, a configuration is realized in which the device connected body according to the present invention expands and contracts as a whole but the device mounted portion does not expand or contract. The device connected body according to the present invention can be manufactured, for example, by the above-described manufacturing method. Hence, the productivity is excellent.

In the configuration, it is preferable that the elastomer layer is continuous to a surface of an interval portion between the plurality of resin layers and a surface of the elastomer layer is formed without a step with respect to a surface of the resin layer at the interval portion.

In the case of the configuration, for example, the device formed surface can be attached to the attachment target surface without any gap since the device formed surface is flat.

### EFFECT OF THE INVENTION

According to the present invention, it is possible to provide a method for manufacturing a device connected body, by which a device connected body is easily manufactured and can be mass-produced. It is also possible to provide the device connected body.

### BRIEF DESCRIPTION OF THE DRAWINGS

Fig. 1 is a schematic sectional view for explaining a method for manufacturing a device connected body according to a first embodiment.
Fig. 2A is a schematic sectional view for explaining a method for manufacturing a device connected body according to a first embodiment.
Fig. 2B is a plan view of Fig. 2A.
Fig. 3A is a schematic sectional view for explaining a method for manufacturing a device connected body according to a first embodiment.
Fig. 3B is a plan view of Fig. 3A.
Fig. 4 is a schematic sectional view for explaining a method for manufacturing a device connected body according to a first embodiment.
Fig. 5 is a schematic sectional view for explaining a method for manufacturing a device connected body according to a first embodiment.
Fig. 6 is a schematic sectional view for explaining a method for manufacturing a device connected body according to a first embodiment.
Fig. 7 is a schematic sectional view for explaining a method for manufacturing a device connected body according to a first embodiment.
Fig. 8 is a schematic sectional view for explaining a method for manufacturing a device connected body according to a first embodiment.
Fig. 9 is a schematic sectional view for explaining a method for manufacturing a device connected body according to a second embodiment.
Fig. 10 is a schematic sectional view for explaining a method for manufacturing a device connected body according to a second embodiment.
Fig. 11 is a schematic sectional view for explaining a method for manufacturing a device connected body according to a second embodiment.
Fig. 12 is a schematic sectional view for explaining a method for manufacturing a device connected body according to a second embodiment.
Fig. 13 is a schematic sectional view for explaining a method for manufacturing a device connected body according to a second embodiment.
Fig. 14 is a schematic sectional view for explaining a method for manufacturing a device connected body according to a second embodiment.
Fig. 15 is a schematic sectional view for explaining a method for manufacturing a device connected body according to a third embodiment.
Fig. 16 is a schematic sectional view for explaining a method for manufacturing a device connected body according to a third embodiment.
Fig. 17A is a schematic sectional view for explaining a method for manufacturing a device connected body according to a third embodiment.
Fig. 17B is a plan view of Fig. 17A.
Fig. 18A is a schematic sectional view for explaining a method for manufacturing a device connected body according to a third embodiment.
Fig. 18B is a plan view of Fig. 18A.
Fig. 19A is a schematic sectional view for explaining a method for manufacturing a device connected body according to a third embodiment.
Fig. 19B is a plan view of Fig. 19A.
Fig. 20A is a schematic sectional view for explaining a method for manufacturing a device connected body according to a third embodiment.
Fig. 20B is a plan view of Fig. 20A.
Fig. 21 is a schematic sectional view for explaining a method for manufacturing a device connected body according to a third embodiment.
Fig. 22 is a schematic sectional view for explaining a method for manufacturing a device connected body according to a third embodiment.
Fig. 23A is a schematic sectional view for explaining a method for manufacturing a device connected body according to a third embodiment.
Fig. 23B is a plan view of Fig. 23A.
Fig. 24 is a schematic sectional view for explaining a method for manufacturing a device connected body according to a third embodiment.
Fig. 25A is a schematic sectional view for explaining a method for manufacturing a device connected body according to a fourth embodiment.
Fig. 25B is a plan view of Fig. 25A.
Fig. 26 is a schematic sectional view for explaining a method for manufacturing a device connected body according to a fourth embodiment.
Fig. 27 is a schematic sectional view for explaining a method for manufacturing a device connected body according to a fourth embodiment.
Fig. 28 is a schematic sectional view for explaining a method for manufacturing a device connected body according to a fourth embodiment.

### MODE FOR CARRYING OUT THE INVENTION

Hereinafter, embodiments of the present invention will be described.

The method for manufacturing a device connected body according to the present embodiment includes:
a step A of preparing a first laminate including an inorganic substrate, a resin layer, and a plurality of devices mounted on the resin layer at intervals in this order;
a step B of obtaining a second laminate by forming an elastomer layer on the first laminate so as to cover the plurality of devices and the interval portion; and
a step C of peeling off the inorganic substrate, and
in the method, the resin layer is formed as a plurality of resin layers at least at positions corresponding to the plurality of devices in advance or as a plurality of resin layers at least at positions corresponding to the plurality of devices by removing a part of the resin layer after the step C of peeling off the inorganic substrate.

Hereinafter, the details of the present embodiment will be described by dividing the present embodiment into first to fourth embodiments.

### [First embodiment]

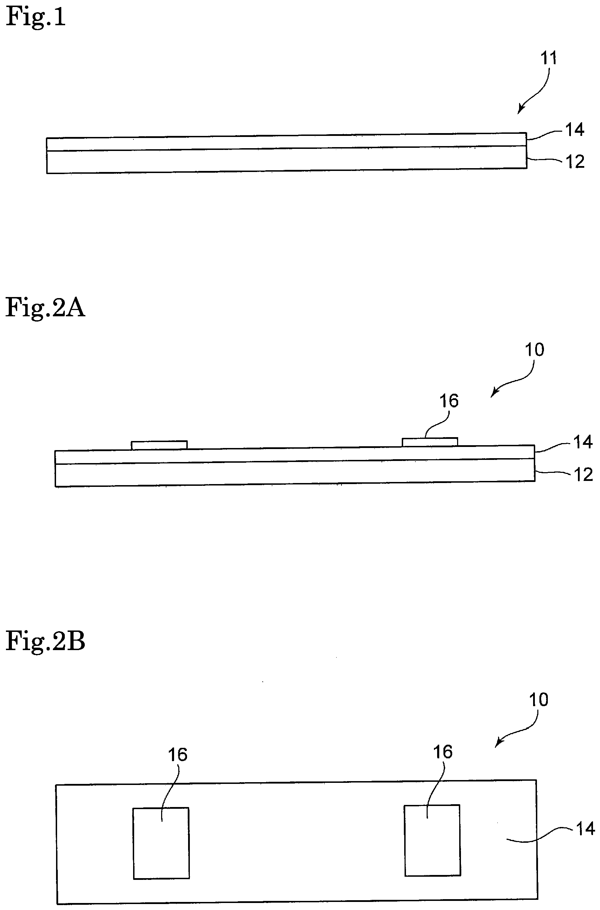

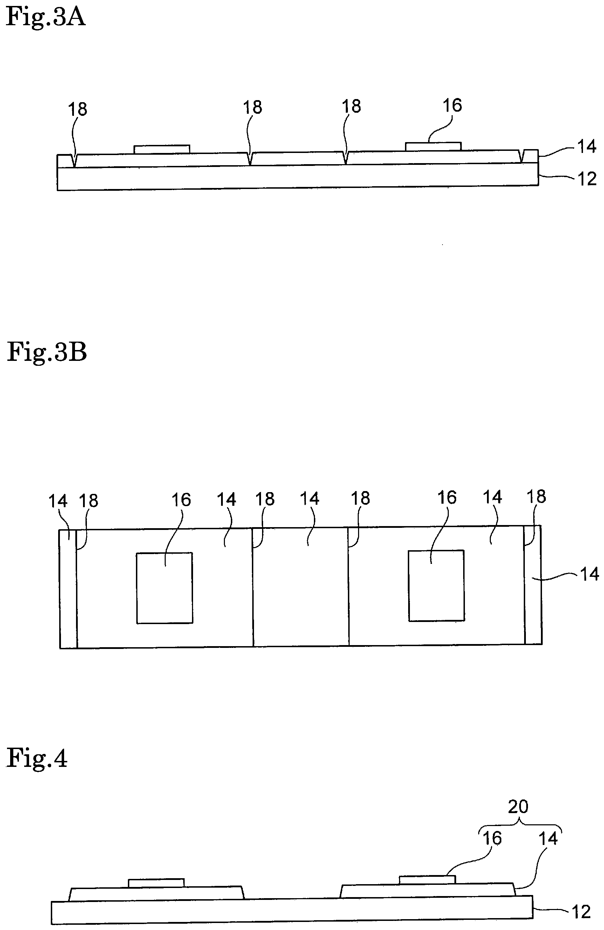

Fig. 1, Fig. 2A, Fig. 3A, and Figs. 4 to 8 are schematic sectional views for explaining a method for manufacturing a device connected body according to a fourth embodiment. Fig. 2B is a plan view of Fig. 2A. Fig. 3B is a plan view of Fig. 3A.

In the method for manufacturing a device connected body according to the first embodiment, a first laminate 10 (see Figs. 2A and 2B) including an inorganic substrate 12, a resin layer 14, and a plurality of devices 16 mounted on the resin layer 14 at intervals in this order is first prepared (step A).

The method for preparing the first laminate 10 is not particularly limited. The first laminate 10 can be obtained by preparing (see Fig. 1) a laminate 11 in which the resin layer 14 is laminated on the inorganic substrate 12 and forming the plurality of devices 16 on the laminate 11 using existing equipment and processes for electronic device fabrication. The first laminate 10 including the inorganic substrate 12, the resin layer 14, and the plurality of devices 16 mounted on the resin layer 14 at intervals in this order may be directly procured.

The first laminate 10 can be manufactured by a known method (see, for example, JP-A-2010-283262, JP-A-2011-011455, JP-A-2011-245675 and the like). Hereinafter, the first laminate 10 will be briefly described.

### <First laminate>

The first laminate 10 includes the inorganic substrate 12, the resin layer 14, and the plurality of devices 16 mounted on the resin layer 14 at intervals in this order.

### <Inorganic substrate>

The inorganic substrate 12 serves as a support when a device is formed on the resin layer 14. The inorganic substrate 12 is peeled off from the resin layer 14 at any stage until the device connected body is completed.

The inorganic substrate 12 may be a plate-type substrate which can be used as a substrate made of an inorganic substance, and examples thereof include those mainly composed of glass plates, ceramic plates, semiconductor wafers, metals and the like and those in which these glass plates, ceramic plates, semiconductor wafers, and metals are laminated, those in which these are dispersed, and those in which fibers of these are contained as the composite of these.

Examples of the glass plates include quartz glass, high silicate glass (96% silica), soda lime glass, lead glass, aluminoborosilicate glass, and borosilicate glass (Pyrex (registered trademark)), borosilicate glass (alkali-free), borosilicate glass (microsheet), aluminosilicate glass and the like.

The semiconductor wafer is not particularly limited, but examples thereof include a silicon wafer and wafers of germanium, silicon-germanium, gallium-arsenide, aluminum-gallium-indium, nitrogen-phosphorus-arsenic-antimony, SiC, InP (indium phosphide), InGaAs, GaInNAs, LT, LN, ZnO (zinc oxide), CdTe (cadmium telluride), ZnSe (zinc selenide) and the like. Among these, the wafer preferably used is a silicon wafer, and a mirror-polished silicon wafer having a size of 8 inches or more is particularly preferable.

The metals include single element metals such as W, Mo, Pt, Fe, Ni, and Au, alloys such as Inconel, Monel, Nimonic, carbon-copper, Fe-Ni-based Invar alloy, and Super Invar alloy, and the like. Multilayer metal plates formed by adding another metal layer or a ceramic layer to these metals are also included.

<Resin layer>

The resin layer 14 is not particularly limited as long as it is a layer formed of a resin but is preferably a heat-resistant polymer film. If the resin layer 14 is a heat-resistant polymer film, the resin layer 14 can withstand the heat generated when the device 16 is formed on the heat-resistant polymer film.

In the present specification, the heat-resistant polymer is a polymer having a melting point of 400°C or more and preferably 500°C or more and a glass transition temperature of 250°C or more, preferably 320°C or more, and more preferably 380°C or more. Hereinafter, the heat-resistant polymer is also simply referred to as a polymer in order to avoid complication. In the present specification, the melting point and the glass transition temperature are determined by differential thermal analysis (DSC). Incidentally, in a case where the melting point exceeds 500°C, it may be determined whether or not the melting point has reached by visually observing the thermal deformation behavior when the heat-resistant polymer is heated at this temperature.

Examples of the heat-resistant polymer film (hereinafter, also simply referred to as a polymer film) includes films of polyimide-based resins (for example, aromatic polyimide resin and alicyclic polyimide resin) such as polyimide, polyamide-imide, polyetherimide, and fluorinated polyimide; copolymerized polyesters (for example, fully aromatic polyesters and semi-aromatic polyesters) such as polyethylene, polypropylene, polyethylene terephthalate, polybutylene terephthalate, and polyethylene-2,6-naphthalate; copolymerized (meth)acrylates represented by polymethylmethacrylate; polycarbonates; polyamides; polysulfones; polyethersulfones; polyetherketones; cellulose acetates; cellulose nitrates; aromatic polyamides; polyvinyl chloride; polyphenols; polyarylates; polyphenylene sulfides; polyphenylene oxides; and polystyrenes.

However, the polymer film is often used in processes involving heat treatment at 450°C or more. Among the polymer films, a film obtained using a so-called super engineering plastic is preferable, and more specific examples include an aromatic polyimide film, an aromatic amide film, an aromatic amide-imide film, an aromatic benzoxazole film, an aromatic benzothiazole film, and an aromatic benzimidazole film.

The thickness of the polymer film is preferably 3 µm or more, more preferably 11 µm or more, further preferably 24 µm or more, and still more preferably 45 µm or more. The upper limit of the thickness of the polymer film is not particularly limited but is preferably 250 µm or less, more preferably 150 µm or less, and further preferably 90 µm or less for use as a flexible electronic device.

The 90° initial peel strength between the inorganic substrate 12 and the resin layer 14 is preferably 0.05 N/cm or more. If the 90° initial peel strength is 0.05 N/cm or more, it is possible to prevent the resin layer 14 from peeling off from the inorganic substrate 12 before and during device formation. In the present specification, the 90° initial peel strength refers to the 90° peel strength between the inorganic substrate and the resin layer after the first laminate is heat-treated at 200°C for 1 hour in an atmospheric ambience.

The measurement conditions for the 90° initial peel strength are as follows.

The resin layer is peeled off from the inorganic substrate at an angle of 90°.

The measurement is performed 5 times and the average value thereof is taken as the measured value.

Measured temperature: Room temperature (25°C)
Peeling speed: 100 mm/min
Ambience: Atmosphere
Width of measured sample: 2.5 cm

The 90° peel strength (Hereinafter, also referred to as "90° peel strength after heating") between the inorganic substrate 12 and the resin layer 14 is preferably 0.50 N/cm or less and more preferably 0.20 N/cm or less after the first laminate is heat-treated at 200°C for 1 hour in an atmospheric ambience and then further heated at 500°C for 1 hour. The 90° peel strength is preferably 0.05 N/cm or more. If the 90° peel strength is 0.50 N/cm or less, the inorganic substrate 12 and the resin layer 14 are easily peeled off from each other after device formation. If the 90° peel strength is 0.05 N/cm or more, it is possible to prevent the inorganic substrate 12 and the resin layer 14 from peeling off from each other at an unintended stage such as during device formation.

The measurement conditions for the 90° peel strength are similar to the measurement conditions for the initial peel strength.

In order to achieve the 90° initial peel strength and the 90° peel strength after heating, it is preferable to provide an adhesive layer between the inorganic substrate and the resin layer.

### <Adhesive layer>

The adhesive layer is not particularly limited as long as it satisfies the 90° initial peel strength and the 90° peel strength after heating but is preferably a silane coupling agent layer.

The details of the silane coupling agent layer are disclosed in, for example, JP-A-2010-283262, JP-A-2011-011455, JP-A-2011-245675 and the like, and the detailed description thereof will be thus omitted here. The silane coupling agent is physically or chemically interposed between the inorganic substrate and the resin layer and has an action of enhancing the adhesive strength (the 90° initial peel strength) between the two. The silane coupling agent also has an action so that the 90° peel strength after heating does not increase too high.

### <Device>

In the present specification, the device refers to a wiring board which carries out electrical wiring and has a single-sided, double-sided, or multi-layered structure, electronic circuits including active devices such as transistors and diodes and passive devices such as resistors, capacitors, and inductors, sensor elements which sense pressure, temperature, light, humidity and the like, biosensor elements, light emitting elements, image display elements such as liquid crystal displays, electrophoresis displays, and self-luminous displays, wireless and wired communication elements, arithmetic elements, storage elements, MEMS elements, power generation elements such as solar cells, power storage elements, thin film transistors, and the like.

In the present specification, the device connected body may have a configuration having one kind of plural devices or may have a configuration having plural kinds of devices. The combination of plural kinds of devices is not particularly limited, and for example, a plurality of the above-mentioned devices can be appropriately combined.

The step (step A) of preparing the first laminate has been described above.

After step A, a cutting line 18 for removing a part of the resin layer 14 is formed on the resin layer 14 by laser irradiation (step X) as illustrated in Figs. 3A and 3B.

Next, the portion of the resin layer 14 on which the device 16 is not laminated is removed along the cutting line 18 as illustrated in Fig. 4. A configuration is thus attained in which a plurality of resin layers 14 are formed at positions corresponding to the plurality of devices 16. In other words, a configuration is attained in which a plurality of laminated products 20 of the resin layer 14 and the device 16 are disposed on the inorganic substrate 12.

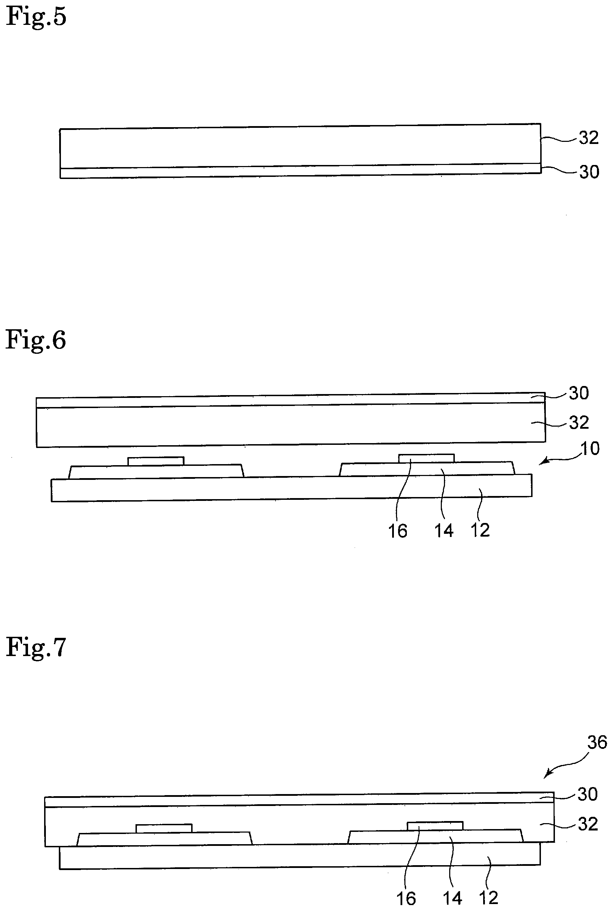

On the other hand, an elastomer layer 32 with a supporting base material 30 is prepared separately from the first laminate 10 (see Fig. 5).

### <Supporting base material>

The supporting base material 30 is for supporting the elastomer layer 32.

Examples of the material for the supporting base material 30 include polyolefin resins such as polyethylene and polypropylene; polyamide resins such as nylon 6 and nylon 66; and polyester resins such as polyethylene terephthalate, polytrimethylene terephthalate, polybutylene terephthalate, polyethylene-2,6-naphthalate, and polytrimethylene terephthalate. These polyester resins which may be used in mixture may be polyester resins obtained by copolymerizing diol components such as diethylene glycol, neopentyl glycol, and polyalkylene glycol, dicarboxylic acid components such as adipic acid, sebatic acid, phthalic acid, isophthalic acid, and 2,6-naphthalenedicarboxylic acid, and the like as copolymerization components. Among these, a polyester resin is preferable from the viewpoint of mechanical strength, chemical resistance, and heat resistance.

Among the polyester resins, polyethylene terephthalate is most preferable from the viewpoint of the balance between physical properties and cost.

### <Elastomer layer>

The elastomer layer 32 exhibits elasticity when being completed as a device connected body. The elastomer layer 32 may be formed of a curable material or a plastic material. The elastomer layer 32 may not exhibit elasticity before being completed as a device connected body. For example, in the case where the elastomer layer 32 is formed of a curable material, the elastomer layer 32 before being cured may not exhibit elasticity.

Examples of the material for the elatosmer layer 32 include silicone rubber, urethane rubber, fluororubber, olefin-based elastomer, styrene-based elastomer, and vinyl chloride-based elastomer.

Next, the elastomer layer 32 with the supporting base material 30 is laminated on the first laminate 10 to obtain a second laminate 36 (see Fig. 7) (step B, step B-1). In the present embodiment, the elastomer layer 32 and the device 16 mounted surface are opposed to each other as illustrated in Fig. 6 and then lamination is performed so that the device 16 and the resin layer 14 are embedded in the elastomer layer 32 as illustrated in Fig. 7 to obtain the second laminate 36. However, in the present invention, step B-1 is not limited to this example. For example, in step B-1, the elastomer layer 32 with the supporting base material 30 may be laminated on the first laminate 10 in a state where only the device 16 is embedded in the elastomer layer 32 but the resin layer 14 is not embedded. In step B-1, the elastomer layer 32 with the supporting base material 30 may be laminated on the first laminate 10 in a state where nothing is embedded in the elastomer layer 32 but the device 16 is attached to the surface of the elastomer layer 32.

Next, the inorganic substrate 12 is peeled off (step C). In addition, the supporting base material 30 is peeled off (step D). Either of the inorganic substrate 12 or the supporting base material 30 may be peeled off first. However, it is preferable to peel off the inorganic substrate 12 first. It is excellent to convey the product in a state where the inorganic substrate 12 is first peeled off but the supporting base material 30 is attached as it is from the viewpoint of being able to convey the product in a state where the elastic portion (elastomer layer 32) is expanded or contracted as little as possible.

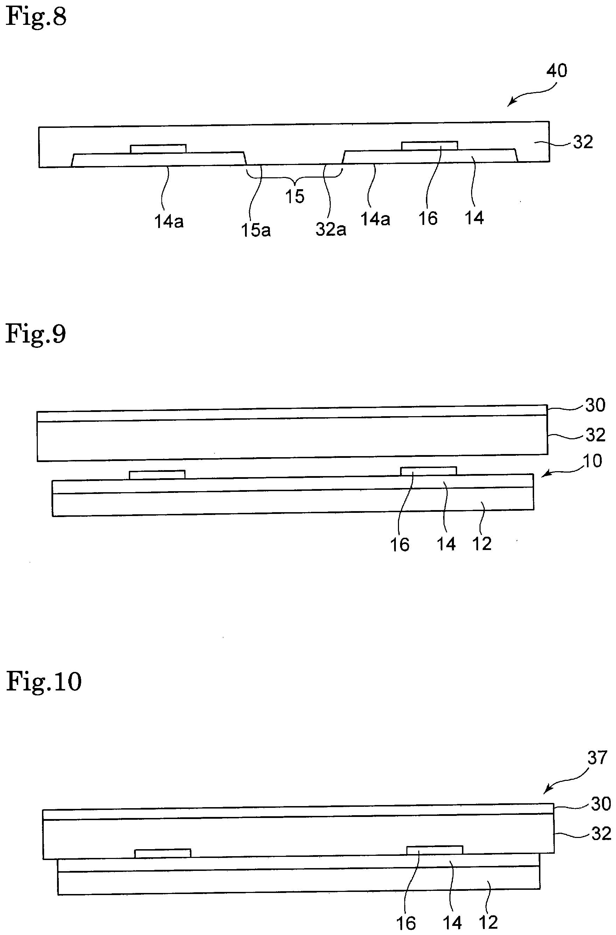

A device connected body 40 is thus obtained (see Fig. 8). Thereafter, the devices 16 may be electrically connected to each other if necessary. At this time, it is preferable to use an elastic wiring pattern for the connection. The method for forming the elastic wiring pattern will be described later.

In the device connected body 40, the elastomer layer 32 is continuous to a surface 15a of an interval portion 15 between the plurality of resin layers 14 and a surface 32a of the elastomer layer 32 is formed without a step with respect to a surface 14a of the resin layer 14 at the interval portion 15. In the device connected body 40, the device formed surface (the surface of the elastomer layer 32 on the surface 32a side) is flat without a step and thus, for example, the device formed surface (the surface of the elastomer layer 32 on the surface 32a side) can be attached to the attachment target surface without any gap.

In the above-described embodiment, a case where an elastomer layer with a supporting base material is used and an elastomer layer is formed on the first laminate to obtain a second laminate has been described. However, the present invention is not limited to this example. For example, the device connected body 40 (see Fig. 8) may be obtained by applying a liquid composition for elastomer layer formation on the resin layer 14 of the first laminate 10 (see Fig. 2A) and curing the composition.

### [Second embodiment]

A method for manufacturing a device connected body according to a second embodiment is common to that according to the first embodiment except that the timing of forming the cutting line on the resin layer and the timing of removing the portion of the resin layer where the device is not laminated along the cutting line are different from those in the method according to the first embodiment. Hence, in the following, the description of the common parts will be omitted or simplified and the different parts will be mainly described. The same reference numerals are used for the configurations common to those of the first embodiment.

Figs. 9 to 14 are schematic sectional views for explaining the method for manufacturing a device connected body according to the second embodiment.

In the method for manufacturing a device connected body according to the second embodiment, a first laminate 10 (see Figs. 2A and 2B) is first prepared (step A).

Next, an elastomer layer 32 with a supporting base material 30 (see Fig. 5) is laminated on the first laminate 10 to obtain a second laminate 37 (see Fig. 10) (step B, step B-1). In the present embodiment, the elastomer layer 32 and the device 16 mounted surface are opposed to each other as illustrated in Fig. 9 and then lamination is performed so that the device 16 is embedded in the elastomer layer 32 as illustrated in Fig. 10 to obtain the second laminate 37.

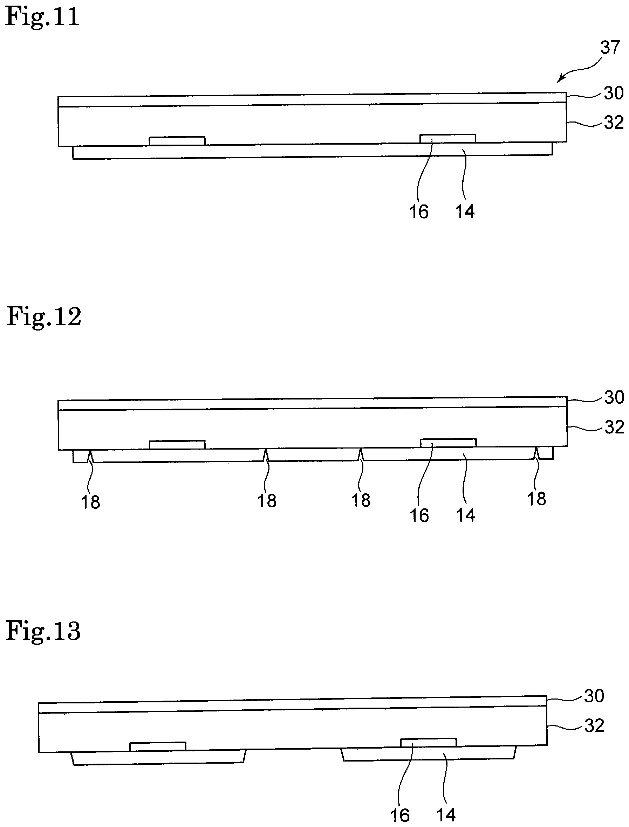

Next, the inorganic substrate 12 is peeled off (step C) as illustrated in Fig. 11.

Next, a cutting line 18 for removing a part of the resin layer 14 is formed on the resin layer 14 by laser irradiation (step E) as illustrated in Fig. 12.

Next, the portion of the resin layer 14 on which the device 16 is not laminated is removed along the cutting line 18 (step F) as illustrated in Fig. 13. A configuration is thus attained in which a plurality of resin layers 14 are formed at positions corresponding to the plurality of devices 16.

In the second embodiment, the cutting line 18 for removing a part of the resin layer 14 is formed on the resin layer 14 by laser irradiation after the step C of peeling off the inorganic substrate 12 (step E) and a plurality of resin layers 14 are formed at least at positions corresponding to the plurality of devices 16 by removing the part (step F), and it is thus possible to confirm the shape after the devices 16 are embedded in the elastomer layer 32 and then to remove the unnecessary portion of the resin layer 14. In other words, the elastomer layer 32 and the first laminate 10 (particularly the resin layer 14) may be deformed in step B, but it is possible to confirm the deformation of these and then to select and remove the unnecessary resin layer portion in the second embodiment.

Thereafter, the supporting base material 30 is peeled off.

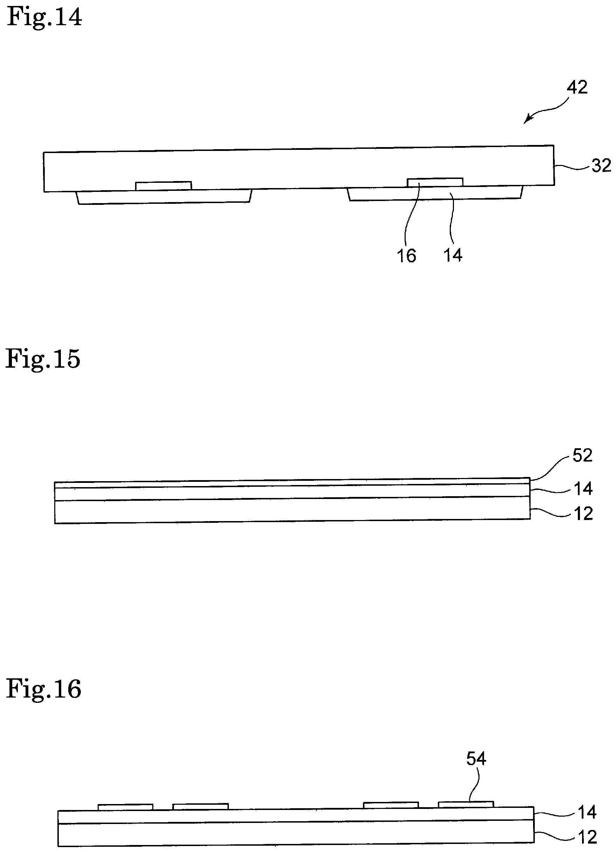

A device connected body 42 according to the second embodiment is thus obtained (see Fig. 14).

### [Third embodiment]

A method for manufacturing a device connected body according to a third embodiment is different in that wiring for connecting the devices to each other is provided. Hence, in the following, the description of the parts common to those of the first embodiment will be omitted or simplified and the different parts will be mainly described. The same reference numerals are used for the configurations common to those of the first embodiment.

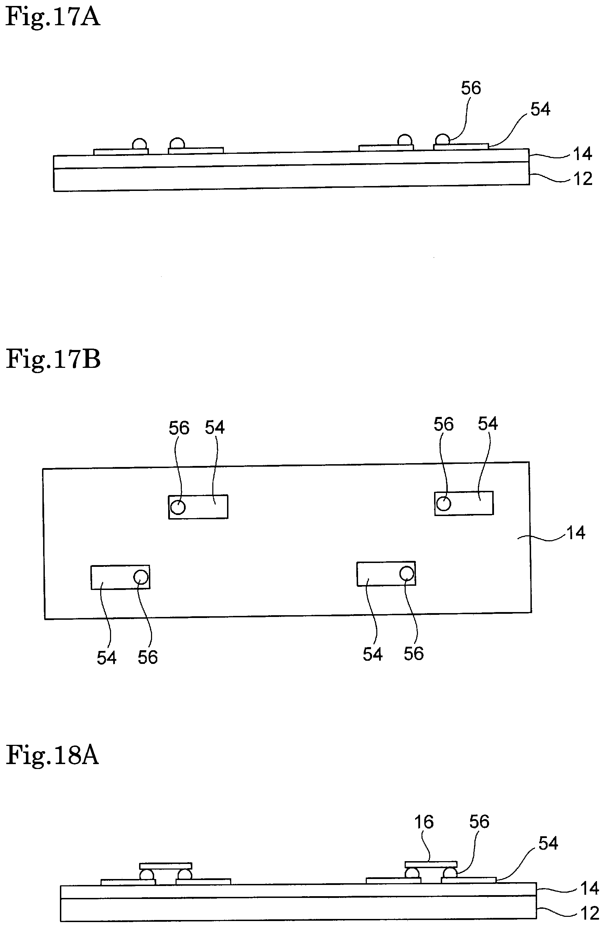

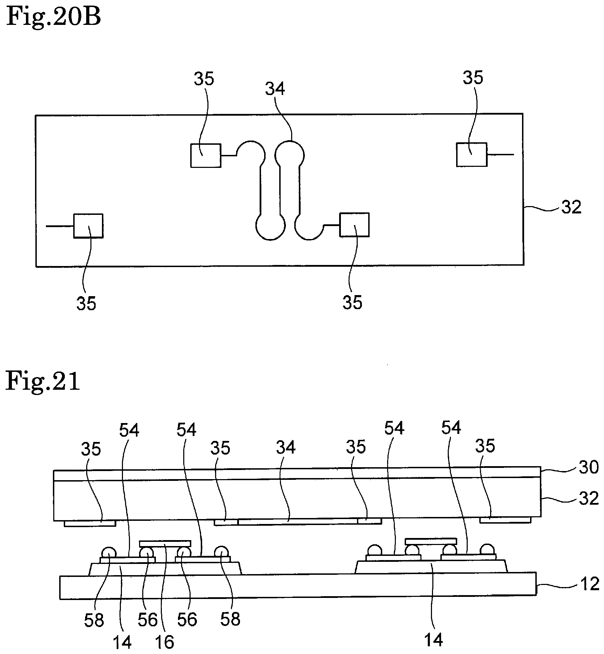

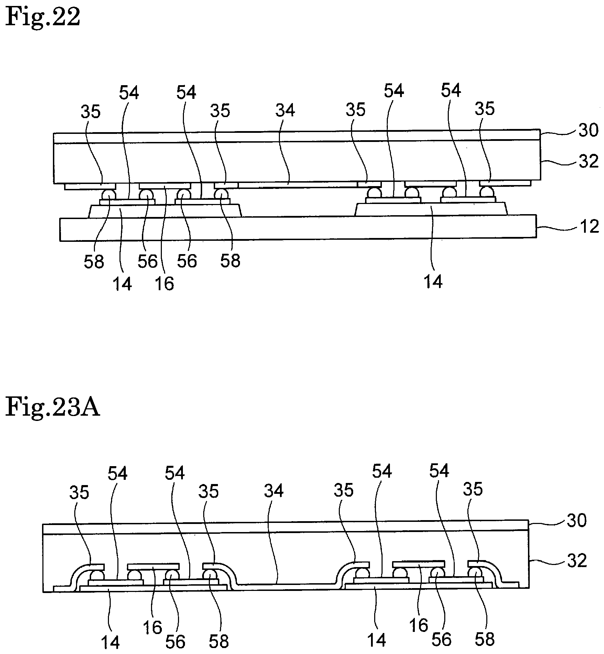

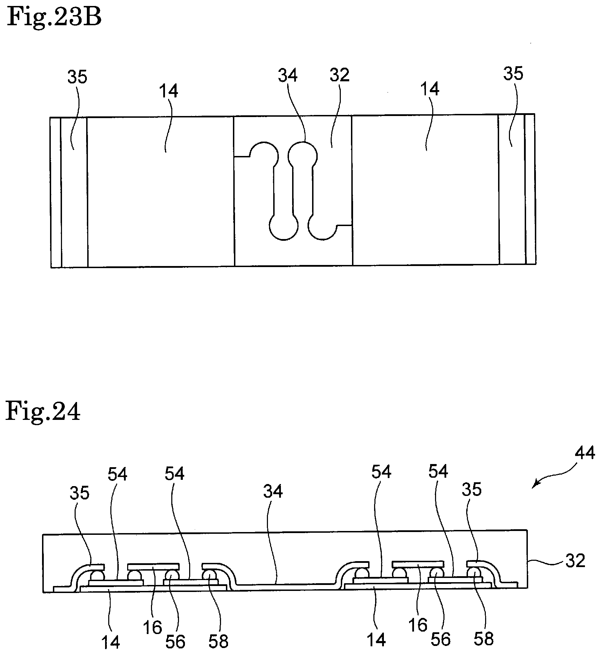

Fig. 15, Fig. 16, Fig. 17A, Fig. 18A, Fig. 19A, Fig. 20A, Fig. 21, Fig. 22, Fig. 23A, and Fig. 24 are schematic sectional views for explaining the method for manufacturing a device connected body according to the third embodiment. Fig. 17B is a plan view of Fig. 17A, Fig. 18B is a plan view of Fig. 18A, Fig. 19B is a plan view of Fig. 19A, Fig. 20B is a plan view of Fig. 20A, and Fig. 23B is a bottom view of Fig. 23A.

In the method for manufacturing a device connected body according to the third embodiment, a laminate 11 in which a resin layer 14 is laminated on an inorganic substrate 12 is first prepared (see Fig. 1).

Next, wiring 54 for electrode take-out is fabricated on the resin layer 14 (see Fig. 16). The method for fabricating the wiring 54 for electrode take-out is not particularly limited, and a conventionally known method can be adopted. For example, the wiring 54 for electrode take-out is fabricated by forming a metal layer 52 on the resin layer 14, then applying a photosensitive resist onto the metal layer 52, and exposing, developing, and etching the photosensitive resist as illustrated in Fig. 15.

Next, a bump 56 is formed at a spot where the device 16 is to be joined on the wiring 54 for electrode take-out as illustrated in Figs. 17A and 17B.

Next, the device 16 is disposed on the bump 56 and the device 16 and the wiring 54 for electrode take-out are joined with the bump 56 interposed therebetween by reflow or the like as illustrated in Figs. 18A and 18B.

Next, a cutting line 18 for removing a part of the resin layer 14 is formed on the resin layer 14 by laser irradiation (step X) as illustrated in Figs. 19A and 19B.

Thereafter, a bump 58 for joining the wiring 54 for electrode take-out and a wiring pattern 34 on an elastomer layer 32 to be described later is formed (see Figs. 19A and 19B). A first laminate 60 is thus obtained.

On the other hand, the elastomer layer 32 with a supporting base material 30 is prepared (see Figs. 20A and 20B) separately from the first laminate 60. The wiring pattern 34 and a circuit lead-out wiring 35 are formed on the elastomer layer 32. The wiring pattern 34 is a conventionally known elastic wiring pattern. The method for forming the wiring pattern 34 and the circuit lead-out wiring 35 on the elastomer layer 32 is not particularly limited, and a conventionally known method can be adopted. For example, the wiring pattern 34 and the circuit lead-out wiring 35 are fabricated by performing sputtering on the elastomer layer 32 so as to have the shapes of the wiring pattern 34 and circuit lead-out wiring 35 using a metal mask and then subjecting the sputtered portion to electroplating to increase the thickness. The wiring pattern 34 is preferably bellows type metal wiring as in the present embodiment.

The wiring pattern 34 may be elastic metal paste wiring formed by applying a conductive composition containing a conductive filler, or the like. As the wiring pattern 34, for example, the conductive pattern described in WO 2015/005204 can be adopted. If the wiring pattern 34 is bellows type metal wiring or elastic metal paste wiring, suitable elasticity between devices 16 can be maintained while maintaining electrical connection between the devices 16.

Next, the portion of the resin layer 14 of the first laminate 60 (see Figs. 19A and 19B) on which the device 16 is not laminated is removed along the cutting line 18. Thereafter, the elastomer layer 32 with the supporting base material 30 (see Figs. 20A and 20B) is laminated on the first laminate 60 to obtain the second laminate (step B, step B-1). In the present embodiment, the elastomer layer 32 and the device 16 mounted surface are opposed to each other as illustrated in Fig. 21, then the two are brought close to each other, and further lamination is performed so that the device 16 is embedded in the elastomer layer 32 as illustrated in Fig. 22 to obtain the second laminate. Thus, the circuit lead-out wiring 35 on the elastomer layer 32 and the bump 58 on the resin layer 14 are also electrically connected.

Next, the inorganic substrate 12 is peeled off (step C). A configuration is thus attained in which a plurality of resin layers 14 are formed at positions corresponding to the plurality of devices 16 (see Figs. 23A and 23B).

Thereafter, the supporting base material 30 is peeled off.

A device connected body 44 according to the third embodiment is thus obtained (see Fig. 24). In the present invention, it is preferable to peel off the supporting base material 30 after the step (step C) of peeling off the inorganic substrate 12 as in the third embodiment. It is thus possible to suppress that the elastomer layer 32 and the wiring pattern 34 on the elastomer layer 32 are expanded or deformed before the second laminate is obtained.

### [Fourth embodiment]

A method for manufacturing a device connected body according to a fourth embodiment is different from that according to the third embodiment in that the wiring pattern and the circuit lead-out wiring are formed on the resin layer 14. Hence, in the following, the description of the parts common to those of the third embodiment will be omitted or simplified and the different parts will be mainly described. The same reference numerals are used for the configurations common to those of the third embodiment.

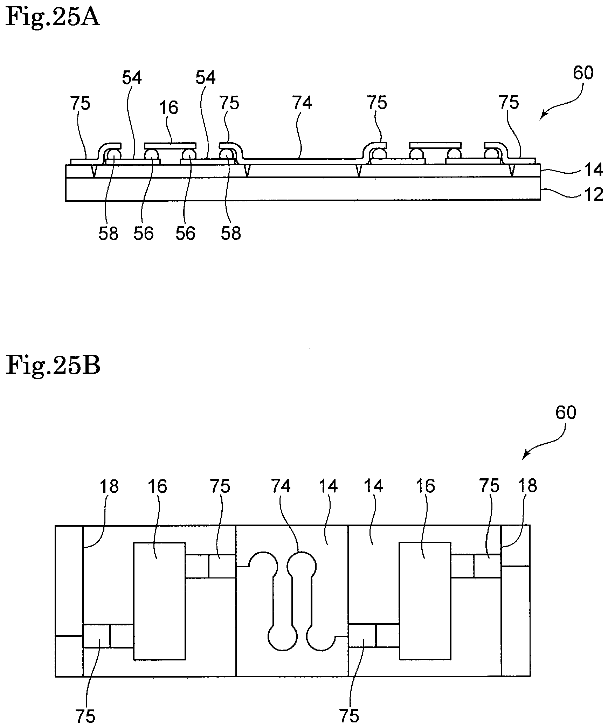

Fig. 25A and Figs. 26 to 28 are schematic sectional views for explaining the method for manufacturing a device connected body according to the fourth embodiment. Fig. 25B is a plan view of Fig. 25A.

In the method for manufacturing a device connected body according to the fourth embodiment, a first laminate 60 is first obtained in the same manner as in the third embodiment (see Figs. 19A and 19B).

Next, a wiring pattern 74 and a circuit lead-out wiring 75 are formed on the first laminate 60 (step G) as illustrated in Figs. 25A and 25B. Specifically, the wiring pattern 74 and the circuit lead-out wiring 75 are formed so that a bump 58 of one device 16 and a bump 58 of another device 16 are electrically connected to each other. The wiring pattern 74 and the circuit lead-out wiring 75 can be formed in the same manner as the wiring pattern 34 and the circuit lead-out wiring 35.

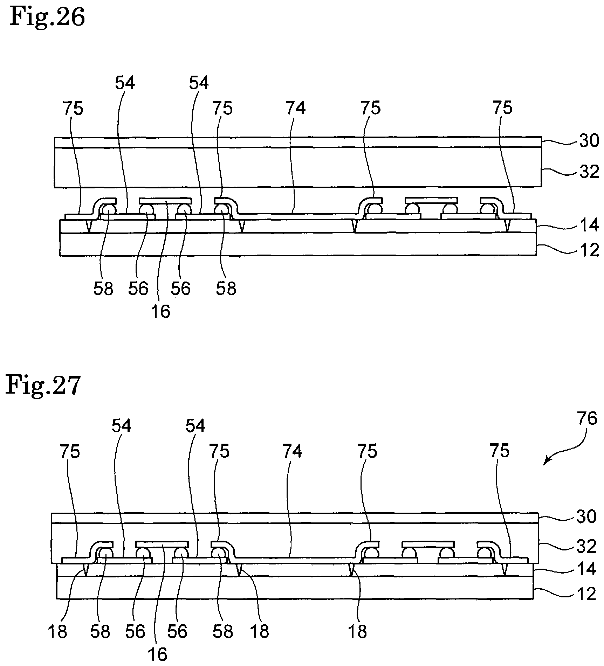

Next, an elastomer layer 32 with a supporting base material 30 (see Fig. 5) is laminated on the first laminate 60 (see Figs. 25A and 25B) to obtain a second laminate 76 (step B, step B-1). In the present embodiment, the elastomer layer 32 and the device 16 mounted surface are opposed to each other as illustrated in Fig. 26, then the two are brought close to each other, and further lamination is performed so that the device 16 is embedded in the elastomer layer 32 as illustrated in Fig. 27 to obtain the second laminate 76.

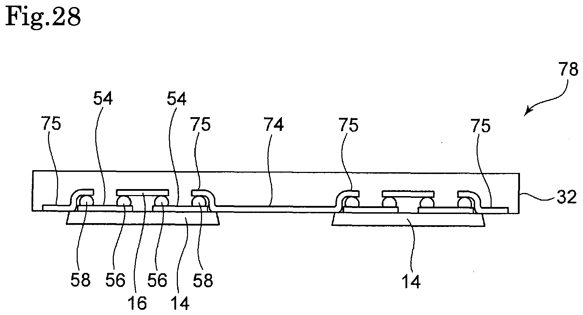

Next, the inorganic substrate 12 is peeled off (step C). Thereafter, the portion of the resin layer 14 on which the device 16 is not laminated is removed along the cutting line 18. A configuration is thus attained in which a plurality of resin layers 14 are formed at positions corresponding to the plurality of devices 16 (see Fig. 28).

Thereafter, the supporting base material 30 is peeled off.

A device connected body 78 according to the fourth embodiment is thus obtained (see Fig. 24).

As described above, according to the present embodiment (first to fourth embodiments and modified examples thereof), it is possible to obtain a device connected body in which a plurality of devices are mounted on an elastic elastomer layer at intervals if only an elastomer layer is formed on the first laminate so as to cover the plurality of devices (step B) and then the inorganic substrate is peeled off (step C). Hence, the productivity is excellent. In addition, although the resin layer is laminated on each device, the resin layer corresponding to each device is not continuous. Hence, one device and another device are connected to each other only by the elastomer layer. As a result, the device connected body obtained by the manufacturing method according to the present embodiment exhibits elasticity.

### EXAMPLES

Hereinafter, the present invention will be described in detail with reference to Examples, but the present invention is not limited to the following Examples as long as the gist of the present invention is not exceeded.

The following Example 1 is Example corresponding to the third embodiment and will be thus described below with reference to the drawings used for the description of the third embodiment as well.

### <Fabrication of device connected body>

### (Example 1)

A glass substrate having a diameter of 200 mm and a thickness of 0.7 mm was prepared. The glass substrate was subjected to ultrasonic water cleaning and ultraviolet/ozone cleaning (UV/O₃ cleaning). For ultraviolet/ozone cleaning, a UV ozone cleaning and reforming apparatus (SKR1102N-03 produced by LANTECHNICAL SERVICE CO., LTD.) was used, and irradiation was performed for 1 minute at a distance of 30 mm from the lamp.

A solution was prepared by diluting 3-aminopropyltrimethoxysilane (KBM-903, produced by Shin-Etsu Chemical Co., Ltd.) with isopropanol so as to have a concentration of 1% by mass.

The glass substrate was installed on a spin coater (MSC-500S, produced by JAPANCREATE, LTD.). The solution was dropped onto the glass substrate, and the spin coater was rotated at a speed of rotation of 5000 rpm and then rotated at a speed of rotation of 2000 rpm to apply the solution to the glass substrate. Thereafter, the coated glass substrate was left on a clean bench for 1 minute for drying, thereby forming a silane coupling agent layer on a glass substrate.

A polyimide film (XENOMAX (registered trademark), produced by TOYOBO CO., LTD.) having a diameter of 196 mm and a thickness of 38 µm was attached onto the silane coupling agent layer. The attachment was performed so that the center of the glass substrate and the center of the polyimide film were aligned. The attachment was performed using a laminator (MRK-1000, produced by MCK CO., LTD.) in a clean room under the conditions of 22°C and 55% RH at a lamination speed of 50 mm/sec and an air source pressure of 0.55 MPa.

Next, a NiCr layer was deposited on the polyimide film surface by about 15 nm using a binary magnetron sputtering apparatus, and then a Cu layer was deposited thereon by about 250 nm. Thereafter, the film thickness of the Cu layer was increased to 5 µm by electroplating.

Next, a photosensitive resist was applied onto the Cu layer, exposed, developed, and etched to fabricate the wiring for electrode take-out (corresponding to the wiring 54 for electrode take-out in Fig. 16).

Next, a solder paste (product name TLF-801-17, produced by TAMURA Corporation) was printed at the spot (corresponding to bump 56 in Fig. 17A) where the chips were joined on the wiring for electrode take-out. The solder paste becomes a bump which electrically connects the chip and the wiring for electrode take-out to each other.

Next, a chip-type thermistor (product name PRF15AR102RB6RC, produced by Murata Manufacturing Co., Ltd., size: 1 mm × 0.5 mm) as a device was placed on the solder paste. Thereafter, a solder joint was formed by reflow (see Fig. 18A). The chip-type thermistors were disposed at 10 mm intervals.

Next, the polyimide film was laser-cut so that one device was separated from another device (see Fig. 19A). The laser cutting was performed by scanning the same spot three times at 8.5 W and 100 Hz using a nanoUV laser (produced by TAKEI ELECTRIC INDUSTRIES CO., LTD.). Cutting lines were vertically and horizontally made on the polyimide film at the portions located at predetermined distances in the length direction and the width direction from the center of the chip-type thermistor.

Thereafter, a solder paste for joining the wiring for electrode take-out and the circuit on the silicone sheet to be described later was printed at a predetermined spot (corresponding to bump 58 in Fig. 19A). The solder paste becomes a bump which electrically connects the wiring for electrode take-out and the circuit on the silicone sheet to be described later to each other.

A first laminate including a glass substrate, a polyimide film, and a plurality of devices mounted on the polyimide film at intervals was thus obtained.

A silicone sheet/PET film laminate (product name: SC50J5S, produced by Maxell Kureha Co., Ltd.) was prepared separately from the first laminate.

An epoxy adhesive as a ground layer was applied onto the silicone sheet and cured. The ground layer was formed only at the portion (circuit lead-out wiring portion) corresponding to the wiring for electrode take-out and the circuit formed portion. Next, the portion other than the circuit lead-out wiring portion and circuit formed portion was covered with a metal mask, and a Cu layer was formed on the ground layer by sputtering to form a circuit. Thereafter, the film thickness of the Cu layer was increased to 10 µm by electroplating (see Fig. 20A).

Next, in order to adhere the silicone sheet to the polyimide film, an adhesive sheet TSU0080 (produced by TOYO INK CO., LTD.) cut-out was roll-laminated on the silicone sheet at 100°C so that only the portion where the circuit did not exist was adhered.

Next, the PET/silicone resin laminate was bonded to the first laminate using a laminator (HAL550, produced by Sankyo Corporation) while performing positioning by image processing to obtain a second laminate. Thereafter, heating was performed at 150°C for 2 minutes. The circuit lead-out wiring on the silicone sheet was thus connected to the solder paste on the polyimide film.

Thereafter, the glass substrate and the polyimide film cut out by the laser were manually peeled off. The PET film was further manually removed. A device connected body according to Example 1 was thus obtained (see Fig. 23A) .

In the obtained device connected body, although the polyimide film was laminated on each device, the polyimide film corresponding to each device was not continuous. Hence, one device and another device are connected to each other only by a silicone sheet. As a result, the device connected body of Example 1 exhibits elasticity. In the device connected body of Example 1, since the devices are connected to each other by the elastic wiring pattern formed on the surface of the silicone sheet, it is possible to supply power to each device, and the like.

### DESCRIPTION OF REFERENCE SIGNS

- 10, 60: First laminate
- 12: Inorganic substrate
- 14: Resin layer
- 14a: Surface
- 15: Interval portion
- 15a: Surface
- 16: Device
- 18: Cutting line
- 30: Supporting base material
- 32: Elastomer layer
- 32a: Surface
- 34, 74: Wiring pattern
- 35, 75: Circuit lead-out wiring
- 36, 37, 76: Second laminate
- 40, 42, 44, 78: Device connected body
- 52: Metal layer
- 54: Wiring for electrode take-out
- 56: Bump
- 58: Bump

## Claims

1. A method for manufacturing a device connected body, the method comprising:
a step A of preparing a first laminate including an inorganic substrate, a resin layer, and a plurality of devices mounted on the resin layer at intervals in this order;
a step B of obtaining a second laminate by forming an elastomer layer on the first laminate so as to cover the plurality of devices and the interval portion; and
a step C of peeling off the inorganic substrate, wherein
the resin layer is formed as a plurality of resin layers at least at positions corresponding to the plurality of devices in advance or as a plurality of resin layers at least at positions corresponding to the plurality of devices by removing a part of the resin layer after the step C of peeling off the inorganic substrate.

2. The method for manufacturing a device connected body according to claim 1, the method comprising a step X of forming a cutting line for removing a part of the resin layer on the resin layer by laser irradiation prior to the step B of obtaining a second laminate.

3. The method for manufacturing a device connected body according to claim 1 or 2, wherein
the step B of obtaining a second laminate includes a step B-1 of laminating an elastomer layer with a supporting base material on the first laminate, and
the method for manufacturing a device connected body further comprises a step D of peeling off the supporting base material.

4. The method for manufacturing a device connected body according to claim 3, wherein the elastomer layer has an elastic wiring pattern on a surface of the elastomer layer for connecting the devices to each other.

5. The method for manufacturing a device connected body according to claim 4, wherein the wiring pattern is bellows type metal wiring or elastic metal paste wiring.

6. The method for manufacturing a device connected body according to claim 1, the method comprising:
a step E of forming a cutting line for removing a part of the resin layer on the resin layer by laser irradiation after the step C of peeling off the inorganic substrate; and
a step F of forming a plurality of resin layers at least at positions corresponding to the plurality of devices by removing the part.

7. The method for manufacturing a device connected body according to claim 1, the method comprising a step G of forming an elastic wiring pattern for connecting the plurality of devices to each other on the first laminate prior to the step B of obtaining a second laminate.

8. The method for manufacturing a device connected body according to any one of claims 1 to 7, wherein the devices are a sensor element or a light emitting element.

9. A device connected body comprising:
an elastomer layer;
a plurality of resin layers adhering to the elastomer layer;
a plurality of devices interposed between the elastomer layer and the plurality of resin layers; and
an elastic wiring pattern for connecting the plurality of devices to each other.

10. The device connected body according to claim 9, wherein the elastomer layer is continuous to a surface of an interval portion between the plurality of resin layers and a surface of the elastomer layer is formed without a step with respect to a surface of the resin layer at the interval portion.
